# EUROPEAN PATENT APPLICATION

(11) **EP 4 840 673 A1**
(43) Date of publication of application: **18.11.2026**
(21) Application number: 26172758.0
(22) Date of filing: 16.04.2026
(51) Int. Cl.: B60L 3/12, B60L 58/16, G01R 31/389, G01R 31/392, H01M 10/42, H01M 10/48

(54) **CONTROLLER AND VEHICLE**

(30) Priority: 16.05.2025 JP 2025082698
(71) Applicant: TOYOTA JIDOSHA KABUSHIKI KAISHA, Toyota-shi, Aichi-ken 471 8571 (JP)
(72) Inventor: YASOSHIMA, Juni, Toyota-shi 471-8571 (JP)
(74) Representative: J A Kemp LLP

(57) **Abstract**

A controller (500) acquires a state of a battery (10, 100) and controls a relay (100b). The controller (500) acquires a resistance decrease amount of the battery from when the relay switches to a disconnected state to when the relay switches to a connected state, by using a first resistance and a second resistance. The first resistance represents a resistance of the battery when the relay switches from the connected state to the disconnected state. The second resistance represents a resistance of the battery when the relay switches from the disconnected state to the connected state (S13). The controller (500) also acquires a first degradation degree representing a resistance increase amount of the battery due to concentration nonuniformity of an electrolyte of the battery, by using the acquired resistance decrease amount and an elapsed time from switching of the relay to the disconnected state to switching of the relay to the connected state (S16).

## Description

### CROSS REFERENCE TO RELATED APPLICATIONS

This nonprovisional application is based on Japanese Patent Application No. 2025-082698 filed on May 16, 2025 with the Japan Patent Office, the entire contents of which are hereby incorporated by reference.

### BACKGROUND

### Field

The present disclosure relates to a controller and a vehicle.

### Description of the Background Art

Japanese Patent Laying-Open No. 2014-003826 discloses a technique of acquiring a degradation degree indicating a resistance increase amount of a battery due to concentration nonuniformity (for example, bias of the ion concentration) of an electrolyte of the battery based on a current (charging current or discharging current) of the battery.

### SUMMARY

In the above-described technique, the state of the battery (for example, bias of the ion concentration) is estimated based on the current of the battery, and the degradation degree indicating the resistance increase amount of the battery is acquired based on the estimated state of the battery. However, when a current flows through the battery, factors affecting the state of the battery increase. It is difficult to predict the state change of the battery during charging and discharging. Therefore, it is not always possible to acquire the degradation degree of the battery with high accuracy by the above-described technique.

The present disclosure has been made to solve the above problems, and an object of the present disclosure is to obtain a resistance increase amount of a battery due to nonuniform concentration of an electrolyte of the battery with high accuracy.

According to one aspect of the present disclosure, a controller that acquires a state of a battery and controls a relay is provided. The relay is configured to permit, in a connected state, the battery to be charged and discharged, and to inhibit, in a disconnected state, the battery from being charged and discharged. The controller is configured to acquire a resistance decrease amount of the battery from when the relay switches to the disconnected state to when the relay switches to the connected state, by using a first resistance and a second resistance. The first resistance represents a resistance of the battery when the relay switches from the connected state to the disconnected state. The second resistance represents a resistance of the battery when the relay switches from the disconnected state to the connected state. The controller is also configured to acquire a first degradation degree by using the acquired resistance decrease amount and an elapsed time from switching of the relay to the disconnected state to switching of the relay to the connected state. The first degradation degree represents a resistance increase amount of the battery due to concentration nonuniformity of an electrolyte of the battery.

The foregoing and other objects, features, aspects and advantages of the present disclosure will become more apparent from the following detailed description of the present disclosure when taken in conjunction with the accompanying drawings.

### BRIEF DESCRIPTION OF THE DRAWINGS

Fig. 1 is a diagram illustrating a configuration of a vehicle according to an embodiment of the present disclosure.
Fig. 2 is a flowchart showing relay control according to the present embodiment.
Fig. 3 is a diagram for explaining a relational formula used in the process shown in Fig. 2.
Fig. 4 is a flowchart showing charging/discharging control according to the present embodiment.
Fig. 5 is a diagram illustrating an operation example of the controller according to the present embodiment.

### DESCRIPTION OF THE PREFERRED EMBODIMENTS

Embodiments of the present disclosure will be described in detail with reference to the drawings. In the drawings, the same or corresponding parts are denoted by the same reference numerals, and the description thereof will not be repeated.

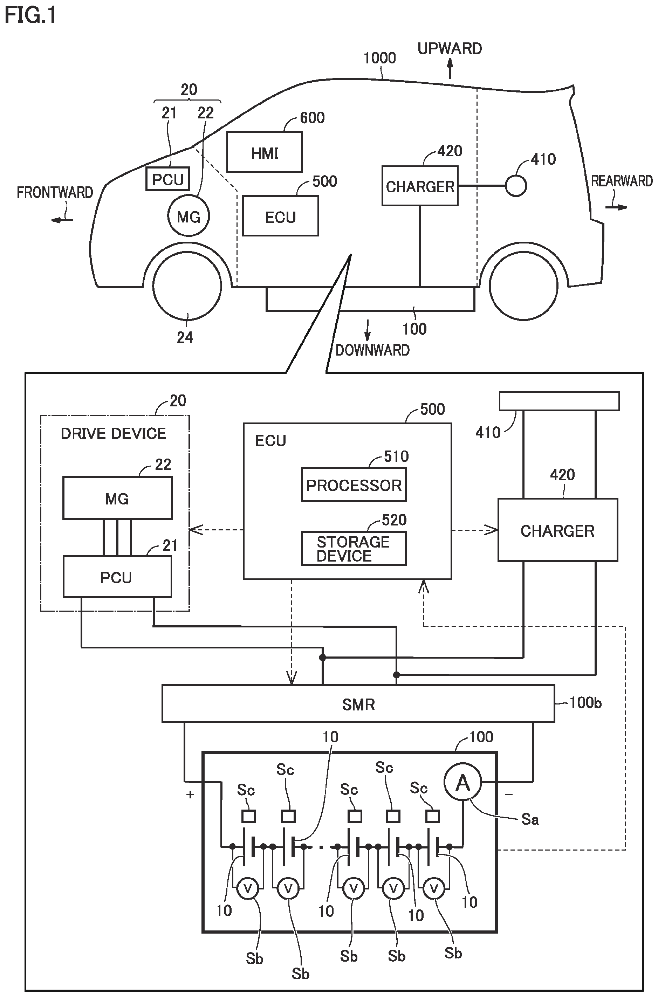

Fig. 1 is a diagram illustrating a configuration of a vehicle 1000 according to this embodiment. The vehicle 1000 includes a battery pack 100 including one or more batteries. The battery pack 100 is fixed, for example, under the floor of the vehicle 1000. However, the mounting mode of the battery pack 100 is arbitrary. For example, the battery pack 100 may be disposed on the floor of the vehicle 1000.

The vehicle 1000 further includes an ECU (Electronic Control Unit) 500 and various sensors (such as a position sensor and an odometer (not shown)) that detect the state of the vehicle 1000 in real time. The detection results of the various sensors are output to the ECU 500.

The ECU 500 includes a processor 510 and a storage device 520. The storage device 520 is configured to save the stored information. In the ECU 500, various controls are executed by the processor 510 executing a program stored in the storage device 520. The storage device 520 further stores various kinds of information used in the program in addition to the program. The ECU 500 has a timer function. The ECU 500 measures an elapsed time from a predetermined event (trigger) by the timer function. The timer function may be realized by a timer circuit (hardware) or may be realized by software. The ECU 500 corresponds to an example of a "controller" according to the present disclosure.

The vehicle 1000 further includes a drive device 20 for driving the vehicle 1000, an inlet 410, a charger 420, and an HMI (Human Machine Interface) 600.

The HMI 600 includes an input device and a display device. The input device includes an activation switch of the vehicle 1000. The display device may include a meter panel and/or a center display. The HMI 600 may include a touch panel display.

The activation switch of the vehicle 1000 is a switch for activating or stopping the vehicle system (including the ECU 500). The state (operation state/stop state) of the vehicle system is switched in accordance with a user operation (on operation/off operation) on the activation switch. In general, the activation switch is referred to as "power switch", "ignition switch", or the like.

The drive device 20 includes a power control unit (PCU) 21 and a motor generator (MG) 22. The vehicle 1000 is configured to be able to travel using electric power output from the battery pack 100. The vehicle 1000 is, for example, a BEV (battery electric vehicle) that does not include an internal combustion engine. However, the vehicle 1000 may be an electrically powered vehicle (xEV) including an internal combustion engine, such as a plug-in hybrid electric vehicle (PHEV) or a hybrid electric vehicle (HEV).

The battery pack 100 includes a plurality of cells 10 (secondary batteries) and functions as a power storage device. In this embodiment, a liquid lithium ion battery is employed as the cell 10. However, the cell 10 may be another secondary battery. The battery pack 100 includes one current sensor Sa, a plurality of voltage sensors Sb provided for each cell 10, and a plurality of temperature sensors Sc provided for each cell 10. The detection results of the respective sensors are output to the ECU 500. The ECU 500 may function as a BMS (Battery Management System) with these sensors. The ECU 500 acquires a state of charge (SOC) of each cell 10 based on the detection result of each sensor. SOC indicates a state of charge. The charge rate corresponds to a ratio of the current amount of stored power to the amount of stored power in the fully charged state.

The vehicle 1000 is configured to perform external charging of the battery pack 100 during parking. The external charging is charging of the in-vehicle battery with electric power supplied from the outside of the vehicle. The inlet 410 is configured to be connectable to a charging cable of a power supply facility outside the vehicle. The charger 420 is an in-vehicle charger that performs AC/DC conversion. During external charging, the charger 420 converts AC power into DC power in accordance with a command from the ECU 500, and outputs the DC power to the battery pack 100. Accordingly, each battery included in the battery pack 100 is charged.

The PCU 21 includes, for example, an inverter. The MG 22 functions as a drive motor and rotates the drive wheels 24 of the vehicle 1000. The MG 22 drives the vehicle 1000 using power output from the battery pack 100 including a plurality of cells 10. Specifically, the PCU 21 drives the MG 22 using power supplied from the battery pack 100. As a result, the MG 22 enters a power running state. The MG 22 in the power running state converts electric power into torque. Torque is transmitted to the drive wheels 24. In addition, the MG 22 enters a regeneration state at the time of deceleration of the vehicle 1000, and charges each cell 10 included in the battery pack 100 with the generated regeneration power.

The vehicle 1000 further includes an SMR (System Main Relay) 100b. The SMR 100b is, for example, an electromagnetic mechanical relay. The SMR 100b is located between the battery pack 100 and each of the drive device 20 and the charger 420. The SMR 100b corresponds to a relay that switches between permission and inhibition of charging and discharging of the battery pack 100 (a plurality of cells 10). The SMR 100b permits charging and discharging of the battery pack 100 when in the connected state (on state), and inhibits charging and discharging of the battery pack 100 when in the disconnected state (off state).

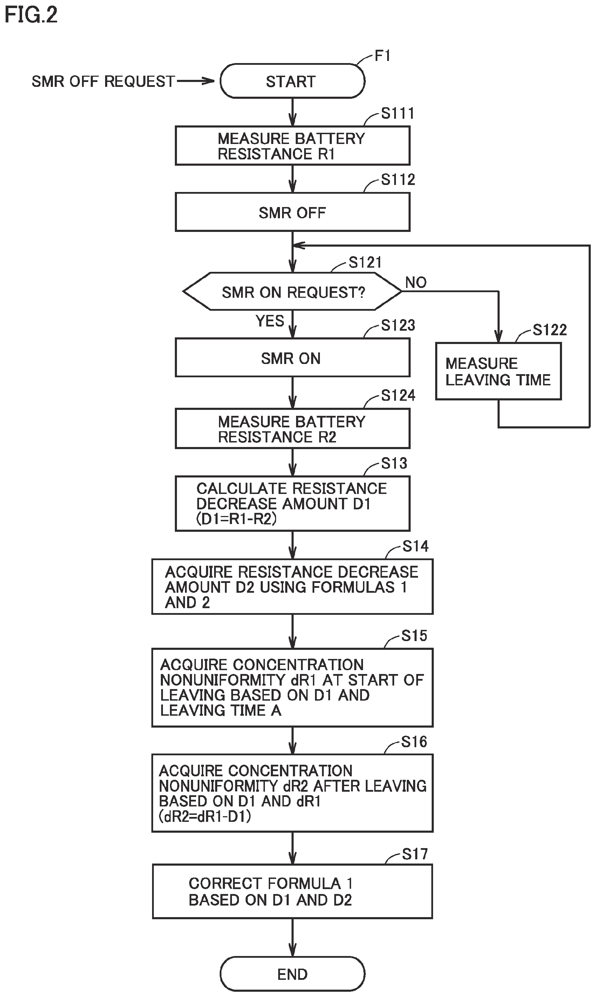

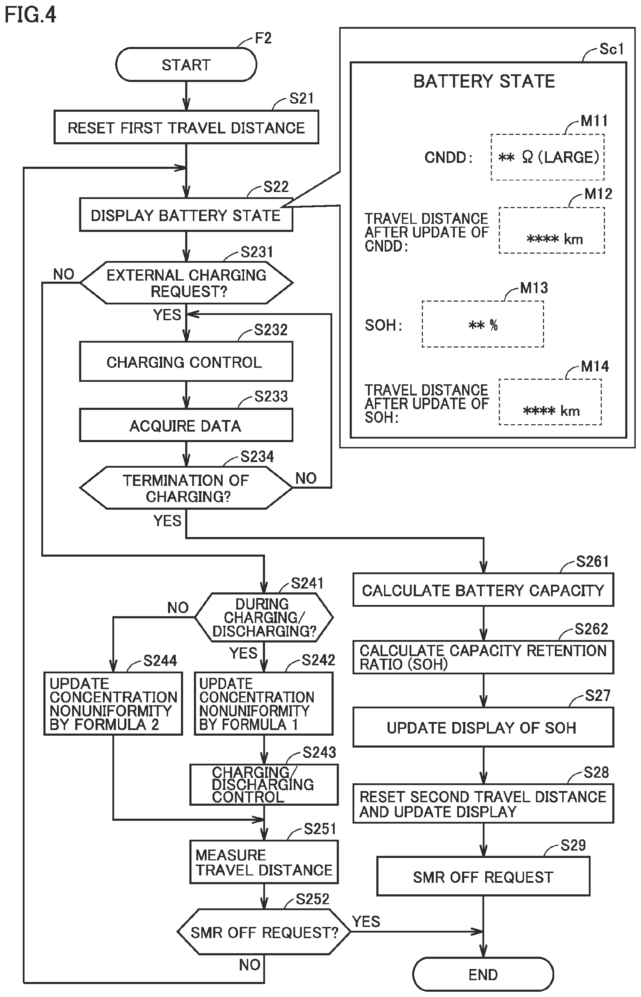

The ECU 500 acquires the state (battery resistance or the like) of the battery pack 100, and controls the SMR 100b. Specifically, when the SMR OFF request is generated while the SMR 100b is in the connected state, the ECU 500 starts the processing flow F1 shown in Fig. 2. Fig. 2 is a flowchart showing relay control by the ECU 500. "S" in the flowchart means a step. The SMR OFF request is generated by, for example, an off operation on the above-described activation switch. The SMR OFF request is also generated by the process of S29 (Fig. 4) described later.

In the processing flow F1 shown in Fig. 2, the ECU 500 measures the battery resistance (hereinafter, referred to as "R1") of the battery pack 100 in S111.

The ECU 500 may acquire the battery resistance (internal resistance of the cell 10) based on the current and the voltage of the cell 10 in a state in which the current flows through the battery (cell 10). The ECU 500 may plot a plurality of data indicating the relationship between the current and the voltage with respect to the cell 10, and acquire the battery resistance based on the slope of a straight line approximating the data. The battery resistance of the battery pack 100 (the plurality of cells 10) may be an average value, a median value, or a maximum value of the battery resistance measured for each of the plurality of cells 10. The ECU 500 may acquire the battery resistance of the battery pack 100 (battery assembly) based on the inter-terminal voltage and current of the battery assembly formed by the plurality of cells 10 connected in series.

In subsequent S112, ECU 500 switches SMR 100b from the connected state to the disconnected state in response to the above-described SMR OFF request. That is, R1 indicates the battery resistance when the SMR 100b is switched from the connected state to the disconnected state.

In subsequent S121, the ECU 500 determines whether or not the SMR ON request has occurred. The SMR ON request is generated by, for example, an ON operation on the activation switch. The SMR ON request may be generated when the start time of the timer charging set in the ECU 500 arrives.

In the period in which the SMR ON request is not generated (NO in S121), the SMR 100b is maintained in the disconnected state, and the process of S122 is executed. When the SMR 100b enters the disconnected state, the ECU 500 enters the stop state (sleep state). As a result, many functions (such as a function related to calculation) of the ECU 500 are stopped, but the timer function is not stopped. In S122, the timer function of the ECU 500 measures time. Thus, the elapsed time from the time when the SMR 100b switches to the disconnected state is measured.

When the SMR ON request is generated while SMR 100b is in the disconnected state (YES in S121), the process proceeds to S123. Thus, the ECU 500 is activated. In addition, the process of S122 is not executed. In S123, the ECU 500 switches the SMR 100b from the disconnected state to the connected state in response to the SMR ON request. That is, the time measured in S122 (hereinafter, referred to as "leaving time A") indicates a time elapsed from when the SMR 100b switches to the disconnected state to when the SMR 100b switches again to the connected state.

In subsequent S124, the ECU 500 measures the battery resistance (hereinafter referred to as "R2") of the battery pack 100. The method of measuring R2 may be the same as the method of measuring R1 (S111). Subsequently, in S13, the ECU 500 subtracts R2 from R1 to calculate the amount of decrease in the battery resistance of the battery pack 100 (hereinafter, referred to as "D1").

In each of the plurality of cells 10 included in the battery pack 100, charging and discharging are performed by movement of charge carriers (for example, lithium ions) in the electrolyte. At this time, concentration nonuniformity of the electrolyte may occur due to charging and discharging. In particular, high-rate charging and discharging easily cause concentration nonuniformity. One example of the concentration nonuniformity of the electrolyte is an uneven distribution of the ion concentration in the electrolyte solution. As the degree of concentration nonuniformity of the electrolyte increases, the battery resistance tends to increase. The degree of concentration nonuniformity of the electrolyte is indicated by, for example, the degree of bias of the ion concentration to the charging side or the discharging side. Hereinafter, the amount of increase in the battery resistance due to the concentration nonuniformity of the electrolyte in the battery pack 100 is referred to as "concentration-nonuniformity degradation degree (CNDD)". As the degree of concentration nonuniformity of the electrolyte of each cell 10 in the battery pack 100 increases, the CNDD increases.

In the leaving period, the concentration nonuniformity of the electrolyte is alleviated with the lapse of time, and the CNDD tends to decrease. The leaving period is a period in which the battery is neither charged nor discharged. A decrease in the CNDD means a decrease in battery resistance. D1 calculated in S13 indicates the resistance decrease amount of the battery pack 100 (the plurality of cells 10) from when the SMR 100b switches to the disconnected state to when the SMR 100b switches to the connected state. The resistance decrease amount corresponds to the relaxation amount of the concentration nonuniformity.

In subsequent S14, the ECU 500 calculates the decrease amount of the battery resistance of the battery pack 100 (hereinafter, referred to as "D2") according to the first formula and the second formula stored in the storage device 520. Similarly to D1, D2 also indicates the resistance decrease amount of the battery pack 100 (plurality of cells 10) from when the SMR 100b switches to disconnected state to when the SMR 100b switches to connected state. The resistance decrease amount also corresponds to the relaxation amount of the concentration nonuniformity. The first formula and the second formula are relational formulas used in S242 and S244 of Fig. 4 described later, respectively.

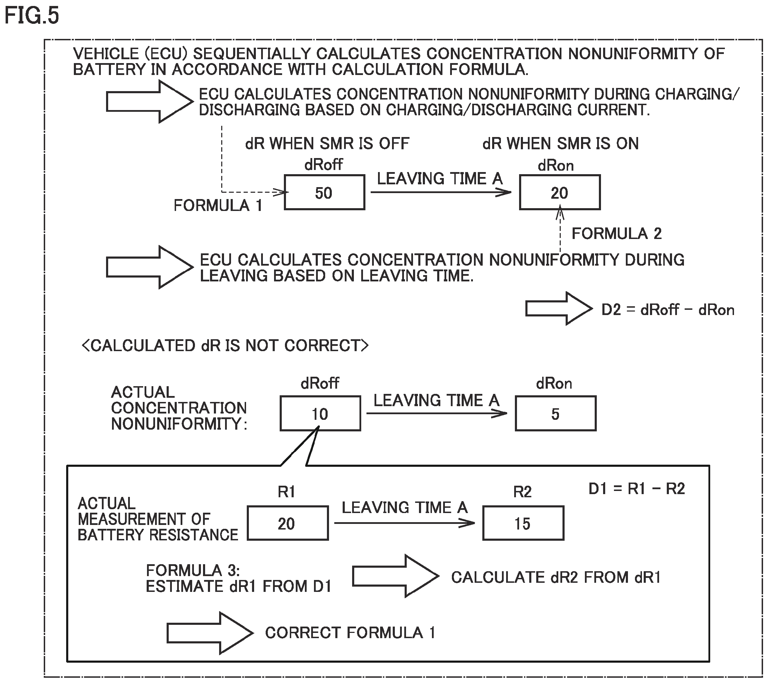

The first formula shows the relationship between the battery current (discharging current or charging current) and the change amount (increase amount or decrease amount) of the CNDD according to the battery current. The first formula is a formula for converting the preceding value of the CNDD into the current value of the CNDD by using the electric current of the battery. The second formula defines a relationship in which the CNDD becomes smaller as the charging/discharging stop time becomes longer. Specifically, the second formula is a formula for converting the CNDD when the charging and discharging are stopped into the CNDD after the elapse of the charging and discharging stop time by using the charging and discharging stop time. For example, the ECU 500 substitutes the leaving time A into the "charging/discharging stop time" in the second formula to calculate the CNDD after leaving and D2. A specific example of the method of calculating D2 will be described later (see Fig. 5).

Subsequently, in S15, the ECU 500 acquires the CNDD at the start of the leaving based on the D1 and the leaving time A acquired as described above. Hereinafter, the CNDD at the start of the leaving is referred to as "dR1". dR1 indicates the CNDD when the SMR 100b is switched from the connected state to the disconnected state, that is, when the process of S112 is executed. Although details will be described later, when the leaving time is the same, dR1 becomes larger as D1 becomes larger.

In subsequent S16, the ECU 500 calculates the CNDD after the leaving on the basis of D1 and dR1. Hereinafter, the CNDD after being left is referred to as "dR2". Specifically, the ECU 500 obtains dR2 by subtracting D1 from dR1 based on the relational formula "D1=dR1-dR2". dR2 indicates the CNDD when the SMR 100b is switched from the disconnected state to the connected state, that is, when the process of S123 is executed. Among dR1, the concentration nonuniformity of the electrolyte that has not been alleviated in the leaving period remains in the battery pack 100 (a plurality of cells 10) as dR2.

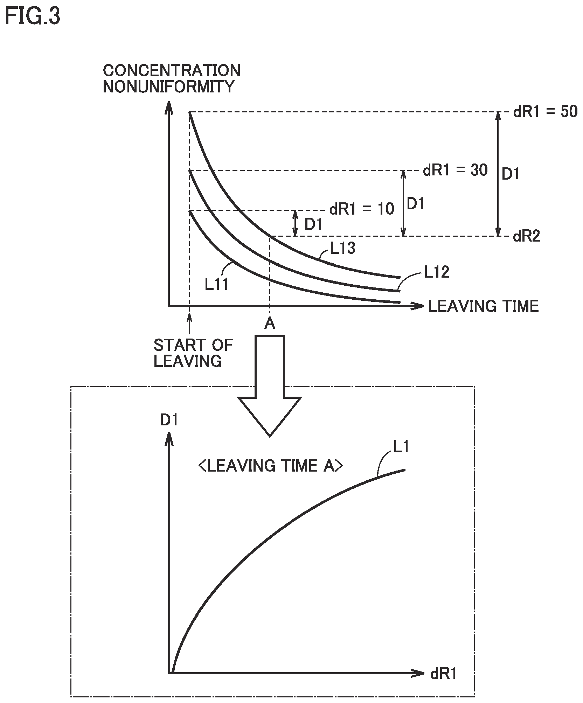

In S15, the ECU 500 acquires dR1 using the third formula stored in the storage device 520. Fig. 3 is a diagram for explaining a relational formula (third formula) used in S15 of Fig. 2. The third formula shows the relationship between the CNDD, D1, the leaving time A, and dR1. The value of dR1 in Fig. 3 is expressed by setting the battery resistance of the battery pack 100 under a predetermined condition to "1" (reference).

As shown in Fig. 3, as the leaving time becomes longer, the concentration nonuniformity of the electrolyte in each cell 10 becomes smaller. The leaving time corresponds to an elapsed time from when the SMR 100b switches to disconnected state. For example, in a case where dR1 is 10, 30, or 50, the third formula indicates a relationship indicated by lines L11, L12, and L13 in Fig. 3, respectively. When the leaving time A is substituted into the third formula, the third formula shows the relationship indicated by the line L1. As indicated by the line L1, when the leaving time is constant (invariant), dR1 increases as D1 increases.

When the process of S16 is executed in the processing flow F1 shown in Fig. 2, the process proceeds to S17. In S17, the ECU 500 corrects at least one of the first formula and the second formula based on D1 (S13) and D2 (S14). Specifically, the accuracy of D1 is higher than that of D2. The ECU 500 may change the parameters in the formulas so as to increase the calculation accuracy of the first formula and the second formula. In this embodiment, only the first formula is corrected. A specific example of the correction will be described later (see Fig. 5).

When the process of S17 is executed, the processing flow F1 ends. Subsequently, the ECU 500 starts the processing flow shown in Fig. 4. Fig. 4 is a flowchart showing charging/discharging control.

In the processing flow F2 shown in Fig. 4, the ECU 500 sets the minimum value (0 km) to the first travel distance stored in the storage device 520 in S21. The first travel distance indicates an integrated travel distance in which the vehicle 1000 travels after dR2 is displayed in the CNDD M11 to be described later. In subsequent S22, the ECU 500 controls the display device of the HMI 600 so that the state of the battery pack 100 is displayed. By this display control, the display device displays, for example, the screen Sc1.

The screen Sc1 displays the CNDD M11, the first travel distance M12, the aging degradation degree M13, and the second travel distance M14 with respect to the battery pack 100. The CNDD M11 indicates a value of the CNDD. The CNDD M11 indicates dR2 acquired in S16 of Fig. 2 in the first processing routine, and indicates dR updated in S242 or S244, which will be described later, in the second and subsequent processing routines. In addition, the CNDD M11 may indicate whether or not the display value (dR2 or dR) of the CNDD exceeds a predetermined reference value by displaying "large" or "small", for example. The first travel distance M12 displays a value of the first travel distance. The first travel distance M12 indicates the minimum value set in S21 in the first processing routine. However, the first travel distance is updated in S251 described later. The aging degradation degree M13 indicates SOH (State of Health). SOH is a parameter indicating the aging degradation degree. In this embodiment, the capacity retention ratio is employed as the SOH. The aging degradation degree M13 is updated in S27 described later. The second travel distance M14 displays the value of the second travel distance. The second travel distance indicates an integrated travel distance in which the vehicle 1000 travels after the display of the SOH is updated. The second travel distance M14 initially indicates a predetermined value (e.g., 0 km). However, the second travel distance is updated in S251 and S28 described later.

In subsequent S231, the ECU 500 determines whether or not an external charging request has occurred. The external charging request may occur when a charging cable of the power supply facility is connected to the inlet 410 (Fig. 1). In addition, the external charging request may be generated when the timer charging start time arrives in a state in which the charging cable of the power supply facility is connected to the inlet 410.

When the external charging request is not generated (NO in S231), the ECU 500 determines whether or not the battery pack 100 is being charged/discharged in S241. If the battery pack 100 is executing either charging or discharging (YES in S241), the process proceeds to S242. When neither charging nor discharging of the battery pack 100 is performed (NO in S241), the process proceeds to S244.

In S242, the ECU 500 updates the CNDD (hereinafter referred to as "dR") of the battery pack 100. As an initial value of dR, dR2 acquired in S16 of Fig. 2 is set. The ECU 500 periodically updates dR based on the first formula.

For example, dR may be a product of the absolute value of the bias index and a coefficient (hereinafter referred to as "k1"). The bias index (hereinafter referred to as "B") indicates the bias of the ion concentration toward the charging side as a positive value, and indicates the bias of the ion concentration toward the discharging side as a negative value. The absolute value of B indicates the degree of concentration nonuniformity of the electrolyte. k1 represents the degree to which the concentration nonuniformity of the electrolyte increases the battery resistance.

In the first processing routine, the ECU 500 sets dR2 acquired in S16 of Fig. 2 as dR. In the second and subsequent processing routines, the ECU 500 updates B based on, for example, the battery current (hereinafter referred to as "Ib") of the battery pack 100 detected by the current sensor Sa (Fig. 1). Ib indicates the charging current with a positive value, and indicates the discharging current with a negative value. The ECU 500 may update B according to the formula "B=B+(k2×Ib)-(k3×B)". In this formula, "B" on the left side indicates the current value, and "B" on the right side indicates the preceding value. k2 is a coefficient indicating the degree to which the battery current affects the ion concentration. k3 is a coefficient related to diffusion of ions. The ECU 500 acquires the dR corresponding to the updated B in accordance with the formula "dR=k1×|B|". The above-described first formula may be a formula obtained by combining the formulas "dR=k1×|B|" and "B=B+(k2×Ib)-(k3×B)" into one formula.

In subsequent S243, the ECU 500 executes charging control or discharging control of the battery pack 100 based on the dR updated in S242.

In the charging control, the ECU 500 controls the input current (charging current) to the battery pack 100 so that the charging current does not exceed the current upper limit value (hereinafter, referred to as "Iin"). The ECU 500 sets Iin based on dR. The ECU 500 decreases the absolute value of Iin as dR increases. The charging current is limited by Iin. Specifically, the ECU 500 may control the PCU 21 (Fig. 1) so that Ib (positive value) is equal to or less than Iin (positive value). As the absolute value of Iin becomes smaller, the limitation of the charging current becomes stronger.

In the discharging control, the ECU 500 controls the output current (discharging current) from the battery pack 100 so that the discharging current does not exceed the current upper limit value (hereinafter, referred to as "Iout"). The ECU 500 sets Iout based on dR. The ECU 500 decreases the absolute value of Iout as dR increases.

The discharging current is limited by Iout. Specifically, the ECU 500 may control the PCU 21 so that Ib (negative value) becomes equal to or greater than Iout (negative value). As the absolute value of Iout becomes smaller, the limitation of the discharging current becomes stronger.

When the process of S243 is executed, the process proceeds to S251.

On the other hand, in S244, the ECU 500 updates dR by the above-described second formula. Specifically, in the first processing routine, the ECU 500 sets dR2 acquired in S16 of Fig. 2 as dR. That is, in the first processing routine, dR becomes dR2 regardless of the determination result of S241. In the second and subsequent processing routines, the ECU 500 updates dR using the second formula. The second formula may be a formula similar to the above-described third formula (see Fig. 3). More specifically, the above-described "leaving time A", "dR1", and "dR2" may be read as "charging/discharging stop time", "dR when charging/discharging is stopped", and "dR when charging/discharging is restarted", respectively. When the process of S244 is executed, the process proceeds to S251.

In S251, the ECU 500 updates each of the first and second travel distances by integrating the distance traveled by the vehicle 1000 using an odometer. While the vehicle 1000 is traveling, since NO is determined in both S231 and S252, the process of S251 is repeatedly executed. As a result, the first and second travel distances increase. As the reliability of the display of each of the CNDD M11 and the aging degradation degree M13 decreases, each travel distance increases.

In subsequent S252, the ECU 500 determines whether or not the above-described SMR OFF request has occurred. When the SMR OFF request is not generated (NO in S252), the process returns to S22. As a result, the next processing routine (the second and subsequent processing routines) in the processing flow F2 is started. On the other hand, when the SMR OFF request is generated (YES in S252), the processing flow F2 ends. Thereafter, the processing flow F1 shown in Fig. 2 is started in response to the SMR OFF request.

When the external charging request is generated (YES in S231), the ECU 500 executes charging control of the battery pack 100 based on the CNDD in S232. In the first processing routine, when it is determined YES in S231, dR2 acquired in S16 of Fig. 2 is set as the CNDD. In the second and subsequent processing routines, when it is determined as YES in S231, the dR updated in S242 or S244 is set as the CNDD. Also in the charging control in S232, the charging current is limited in a manner similar to the charging control in S243. Specifically, the ECU 500 decreases the absolute value of Iin as the CNDD increases. The ECU 500 controls the input current (charging current) to the battery pack 100 so that the charging current does not exceed Iin.

External charging of the battery pack 100 is executed by the charging control of S232. In subsequent S233, the ECU 500 acquires data for obtaining the aging degradation degree of the battery pack 100 and stores the data in the storage device 520. In subsequent S234, the ECU 500 determines whether or not the termination condition of the external charging is satisfied. For example, the external charging termination condition may be satisfied when the SOC of the battery pack 100 reaches the target SOC. The SOC of the battery pack 100 may be the highest SOC among the SOCs of the cells 10 included in the battery pack 100.

In a period in which the external charging termination condition is not satisfied (NO in S234), each step from S232 to S234 is repeated. As a result, external charging (charging of each cell 10) is continuously performed. When the termination condition of the external charging is satisfied (YES in S234), the ECU 500 calculates capacity C1 of battery pack 100 (a plurality of cells 10) in accordance with, for example, the formula "C1=100×dST/|SOC1-SOC2|" in S261. The capacity C1 corresponds to the amount of electric power stored in the battery pack 100 at the time of full charge. "SOC1" means the SOC at the start of charging. "SOC2" means the SOC at the end of charging. "dST" means a charging power amount. The charging power amount indicated by dST corresponds to the power amount input to the battery pack 100 by the external charging. For example, in a case where the charging power amount when the SOC of the battery pack 100 is increased from 10% to 60% by external charging is "25 kWh", the capacity C1 becomes "50 kWh (=100×25/50)".

Subsequently, in S262, the ECU 500 calculates the capacity retention ratio of the battery pack 100 (the plurality of cells 10). The capacity retention ratio indicates the ratio of the current capacity to the initial capacity. The initial capacity is stored in the storage device 520. The current capacity is the capacity C1. As the aging degradation degree of the battery pack 100 increases, the capacity retention ratio of the battery pack 100 decreases.

In subsequent S27, the ECU 500 controls the display device to update the display of aging degradation degree M13. Specifically, the ECU 500 controls the display device of the HMI 600 such that the capacity retention ratio (SOH) of the battery pack 100 acquired in S262 is displayed.

In subsequent S28, the ECU 500 sets the minimum value (0 km) to the second travel distance. Then, the ECU 500 controls the display device to update the display of the second travel distance M14. Subsequently, the ECU 500 ends the processing flow F2 after generating the SMR OFF request in S29. As a result, the processing flow F1 shown in Fig. 2 is started in response to the SMR OFF request.

In this embodiment, during a period in which the SMR 100b is in the connected state and the battery pack 100 is not being externally charged, the ECU 500 sequentially updates the CNDD (dR) by the first formula (S242) or the second formula (S244). In particular, while the battery pack 100 is being discharged (e.g., while the vehicle 1000 is traveling), the ECU 500 estimates the state of the battery (e.g., the bias index) based on the discharging current, and calculates the CNDD (dR) based on the estimated state of the battery. According to such a method, the CNDD (dR) can be easily acquired in real time. However, when a current flows through the battery, factors affecting the state of the battery increase. It is difficult to predict the state change of the battery during charging and discharging. For this reason, it is not always possible to acquire the CNDD (dR) with high accuracy by the first formula.

Therefore, the controller (ECU 500) according to this embodiment acquires D1 by using the first resistance (R1) indicating the battery resistance when the SMR 100b is switched from the connected state to the disconnected state and the second resistance (R2) indicating the battery resistance when the SMR 100b is switched from the disconnected state to the connected state (S13 of Fig. 2). D1 indicates the amount of decrease in the battery resistance of the battery pack 100 from when the SMR 100b switches to disconnected state to when the SMR 100b switches to connected state. The ECU 500 acquires dR2 by using the acquired D1 and the leaving time A (S16 in Fig. 2). The leaving time A indicates a time elapsed from when the SMR 100b switches to disconnected state to when the SMR 100b switches to connected state. dR2 represents an amount of increase in battery resistance due to concentration nonuniformity of the electrolyte of each cell 10 included in the battery pack 100. dR2 and dR correspond to examples of the "first degradation degree" and the "second degradation degree" according to the present disclosure, respectively.

As described above, the ECU 500 acquires the CNDD (dR2) based on the change in the state of the battery during the leaving period. The leaving period corresponds to a period in which no current flows through each cell 10 included in the battery pack 100. More specifically, the ECU 500 acquires the CNDD (dR2) using the battery resistance at the start timing of the leaving period, the battery resistance at the end timing of the leaving period, and the length of the leaving period. In the leaving period, there are few factors affecting the state of the battery. The change in the state of the battery during the leaving period is easily predicted. Therefore, according to the above-described method, it is possible to acquire the resistance increase amount of the battery due to the concentration nonuniformity of the electrolyte of the battery with high accuracy.

Fig. 5 is a diagram for explaining an operation example of the controller (ECU 500) according to this embodiment. The values of dRoff, dRon, dR1, dR2, R1, and R2 in Fig. 5 are expressed by setting the battery resistance of the battery pack 100 under a predetermined condition to "1" (reference).

The dR when the processing flow F2 shown in Fig. 4 ends corresponds to the dR when the SMR 100b switches from the connected state to the disconnected state. Hereinafter, dR when the SMR 100b is switched from the connected state to the disconnected state is referred to as "dRoff". In S14 of Fig. 2, the ECU 500 calculates D2 according to the formula "D2=dRoff-dRon". dRon represents dR when the SMR 100b is switched to the connected state again after the leaving time A has elapsed since the SMR 100b was switched to the disconnected state. The ECU 500 calculates dRon from dRoff and the leaving time A using the second formula. In the example shown in Fig. 5, the calculated dRoff and dRon are 50 and 20, respectively. Therefore, D2 calculated from dRoff and dRon is 30. On the other hand, the actual CNDD when the SMR 100b is switched to the disconnected state and the connected state is 10 and 5, respectively.

In the example illustrated in Fig. 5, R1 acquired in S111 of Fig. 2 is 20, and R2 acquired in S124 of Fig. 2 is 15. Therefore, D1 acquired in S13 of Fig. 2 is 5. In S15 of Fig. 2, dR1 indicating substantially the same value as the actual CNDD (10) is acquired based on D1. In S16 of Fig. 2, dR2 indicating substantially the same value as the actual CNDD (5) is acquired based on dR1.

In S17 of Fig. 2, the parameter(s) (for example, at least one of k1, k2, and k3) in the first formula may be changed based on D1(5) and D2(30). In the example shown in Fig. 5, D2 is larger than D1. Therefore, the ECU 500 may reduce k1 or k2 in S17. Conversely, when D2 is smaller than D1, the ECU 500 may increase k1 or k2 in S17. In S17, the ECU 500 may increase the degree of change of the parameter in the first formula as the difference between D1 and D2 increases.

In the above embodiment, the processing flows F1 and F2 are executed by one or more processors executing programs stored in one or more storage devices. However, these processes may be executed only by hardware (electronic circuit). Further, the processing flows F1 and F2 can be appropriately changed. For example, the order of processing may be changed or unnecessary steps may be omitted depending on the purpose. Further, the contents of any of the processes may be changed. The vehicle is not limited to a passenger car and may be a bus or a truck. The configuration of the vehicle shown in Fig. 1 can be changed as appropriate. The in-vehicle battery may be configured to be wirelessly chargeable.

Each of the first resistance and the second resistance may be a circuit impedance including a battery resistance instead of the battery resistance itself. The display device that displays the degree of the concentration nonuniformity of the electrolyte in the battery (for example, see the CNDD M11 shown in Fig. 4) is not limited to the in-vehicle HMI, and may be a mobile terminal configured to be portable by a user. Examples of mobile terminals include smartphones, wearable devices, scanning tools, and the like. At least a part of the function of the ECU 500 (particularly, the function of executing each process in the processing flows F1 and F2) may be implemented in a mobile terminal or a server. The server may be a server on the cloud. The use of the controller is arbitrary. The controller may be applied not to an in-vehicle battery but to a stationary battery.

Although the present disclosure has been described and illustrated in detail, it is clearly understood that the same is by way of illustration and example only and is not to be taken by way of limitation, the scope of the present disclosure being interpreted by the terms of the appended claims.

## Claims

1. A controller (500) that acquires a state of a battery (10, 100) and controls a relay (100b), wherein
the relay is configured to permit, in a connected state, the battery to be charged and discharged, and to inhibit, in a disconnected state, the battery from being charged and discharged, and
the controller is configured to
acquire a resistance decrease amount (D1) of the battery from when the relay switches to the disconnected state to when the relay switches to the connected state, by using a first resistance (R1) and a second resistance (R2), the first resistance representing a resistance of the battery when the relay switches from the connected state to the disconnected state, the second resistance representing a resistance of the battery when the relay switches from the disconnected state to the connected state, and
acquire a first degradation degree (dR2) by using the acquired resistance decrease amount and an elapsed time from switching of the relay to the disconnected state to switching of the relay to the connected state, the first degradation degree representing a resistance increase amount of the battery due to concentration nonuniformity of an electrolyte of the battery.

2. The controller according to claim 1, wherein
the controller is configured to periodically update a second degradation degree (dR) based on a predetermined formula after switching of the relay from the disconnected state to the connected state,
the first degradation degree is set as an initial value of the second degradation degree, and
the predetermined formula represents a relationship between a preceding value of the second degradation degree and a current value of the second degradation degree.

3. The controller according to claim 2, wherein
the predetermined formula is a formula for converting the preceding value of the second degradation degree to the current value of the second degradation degree, by using electric current of the battery, and
the controller is configured to correct a parameter in the predetermined formula based on the first degradation degree.

4. The controller according to claim 2, wherein the controller is configured to set an electric current upper limit value based on the second degradation degree, and perform at least one of charging control and discharging control for the battery based on the set electric current upper limit value.

5. A vehicle (1000) comprising: the controller according to any one of claims 1 to 4; the battery; and the relay, wherein
the controller is configured to perform display control to display a degree of concentration nonuniformity of the electrolyte in the battery, based on the first degradation degree.
